# EUROPEAN PATENT APPLICATION

(11) **EP 4 621 848 A1**
(43) Date of publication of application: **24.09.2025**
(21) Application number: 24164854.2
(22) Date of filing: 20.03.2024
(51) Int. Cl.: H01L 27/02, H01L 21/768, H01L 23/528, H01L 27/092, H01L 27/118

(54) **A SEMICONDUCTOR DEVICE**

(71) Applicant: Imec VZW, 3001 Leuven (BE)
(72) Inventor: SHERAZI, Syed Muhammad Yasser, 3360 Lovenjoel (BE); RASSOUL, Nouredine, 1440 Braine le Chateau (BE); KIM, Ryan Ryoung han, 3060 Bertem (BE)
(74) Representative: Lind Edlund Kenamets Intellectual Property AB

(57) **Abstract**

In an aspect there is provided a semiconductor device comprising:
a plurality of circuit cells, each circuit cell comprising:
first and second active regions extending in parallel in a first cell direction;
at least a first gate structure extending in a second cell direction transverse to the first cell direction to overlap a respective first channel region of each of the first and second active regions, wherein the first gate structure extends continuously between the first and second active regions;
wherein the first active region comprises a first S/D region at a first side of the first gate structure, and the semiconductor device further comprises a local interconnect configured to couple the first S/D region to a transistor feature at a second side of the first gate structure opposite the first side,
wherein the transistor feature is a second S/D region of the first or second active region, or a second gate structure of the circuit cell, parallel to the first gate structure,
wherein the local interconnect comprises a first portion abutting the first S/D region, a second portion abutting the transistor feature, and an intermediate portion extending between the first and second portions through a cut-out formed in the first gate structure.

## Description

### TECHNICAL FIELD

The present invention generally relates to a semiconductor device comprising a plurality of circuit cells.

### BACKGROUND

Standard cell methodology enables a circuit designer to efficiently design an integrated circuit (IC) by combining standard cells (SDCs) from a standard cell library. Each standard cell of a standard cell library may comprise a set of active devices (e.g., transistors such as n-type or p-type field-effect transistors (FETs)) and/or passive devices, and associated metal interconnects and be configured to provide a certain circuit function (e.g. a basic or a composite logic function such as NOT, AND, OR, NOR, etc., a data storage function, or the like).

To increase the device density and performance of ICs, considerable effort has been put into advancing design and process technology to reduce the cell height of standard cells, and to optimize usage of routing resources in the metal line layers above the cell area (e.g., in the "Mint" and/or "M1" metal line layers) to mitigate routing congestion and enable standard cell track height reduction.

### SUMMARY

In circuit cells of a standard cell design, the active regions of the active devices are typically provided in a unidirectional pattern extending in a first direction. The active regions are overlapped by gate structures extending in a second direction transverse to the first direction. The first direction is conventionally oriented along the width dimension of the cell, while the second direction is oriented along the height dimension of the cell. The S/D contacts are disposed between and alongside the gate structures. Accordingly, the gate structures block a longitudinal extension of the S/D contacts along the first ("horizontal") direction.

Due to this "horizontal blockage" of the S/D contacts, occasioned by the gate structures, conventional standard cell designs typically utilize routing resources in the middle-of-line (MOL) and/or back-end-of-line (BEOL) (e.g., "Mint" and/or "M1" metal line layers), to bridge the gate structures when inter-cell signal routing along the horizontal direction is needed. However, as realized by the inventors, this may add to the routing complexity and routing congestion over the circuit cells, and may further hinder or complicate standard cell height reduction, in particular at the aggressive pitches employed in advanced technology nodes of the state of the art. It is an object of the present invention to provide techniques addressing these challenges.

According to an aspect of the present invention, there is provided a semiconductor device comprising:
a plurality of circuit cells, each circuit cell comprising:
first and second active regions extending in parallel in a first cell direction;
at least a first gate structure extending in a second cell direction transverse to the first cell direction to overlap a respective first channel region of each of the first and second active regions, wherein the first gate structure extends continuously between the first and second active regions;
wherein the first active region comprises a first source/drain (S/D) region at a first side of the first gate structure, and the semiconductor device further comprises a local interconnect configured to couple the first S/D region to a transistor feature at a second side of the first gate structure opposite the first side,
wherein the transistor feature is a second S/D region of the first or second active region, or a second gate structure of the circuit cell, parallel to the first gate structure,
wherein the local interconnect comprises a first portion abutting the first S/D region, a second portion abutting the transistor feature, and an intermediate portion extending between the first and second portions through a cut-out formed in the first gate structure.

As used herein, the first cell direction and the second cell direction denote respective in-plane directions of a circuit cell, wherein the first cell direction is parallel to the width dimension of the circuit cell (i.e., the cell width), and the second cell direction is transverse to the first cell direction and parallel to the height dimension of the circuit cell (i.e. the cell height). Accordingly, the first cell direction and the second cell direction may interchangeably be referred to as the horizontal direction and the height direction, respectively. Consequently, both the first cell direction (horizontal direction) and the second cell direction (height direction) refer to directions parallel to the plane of extension or footprint of the circuit cell (i.e., the area subtended on a frontside of a substrate supporting the circuit cell).

According to the semiconductor device of the present aspect, the "horizontal blockage" by the gate structures in conventional circuit cells, as discussed above, may be circumvented by providing a gate structure with a cut-out such that a local interconnect may be arranged to extend through the gate structure. The local interconnect may thus be extended along the horizontal direction, in addition to the height direction. The ability to route the local interconnect along two dimensions of the circuit cell (which for brevity may be referred to merely as "cell" in the following) allows a signal to be routed from one side to the other side of the (first) gate structure without utilizing routing resources in the Mint and/or M1 metal line layers. This in turn facilitates further cell height reduction, e.g., by enabling reduced track height implementations of some types of standard cells, as will be further explained in the following. It is to be noted that this "across-gate-signal routing" or "gate-flyover" is allowed while the gate structure extends continuously, i.e. uninterrupted, between the first and second active regions.

To facilitate individual and concise references to the various elements (e.g., structures, portions, contacts and regions) of each circuit cell, elements associated with the first active region may in the following be prefixed by the label "first" and elements associated with the first active region may be prefixed by the label "second". For example, the first S/D region of the first active region may be referred to as the first first S/D region, the first S/D region of the second active region may be referred to as the second first S/D region, a second S/D region of the first active region may be referred to as the first second S/D region and a second S/D region of the second active region may be referred to as the second second S/D region, and so on.

The first portion of the local interconnect abutting the first first S/D region may be interchangeably referred to as the first first S/D contact portion of the local interconnect.

In case the transistor feature is a second S/D region (e.g., a first second S/D region or a second second S/D region), the local interconnect and the cut-out in the gate structure allows the first first S/D region and the (first/second) second S/D region to be interconnected by the local interconnect. This may be useful to realize circuit cells implementing a function (e.g. logic function, storage function) requiring a source or drain of a first transistor to be coupled to a source or drain of a second transistor, such as a NAND or NOR gate. The second portion of the local interconnect abutting the second S/D region may in this case interchangeably be referred to as the first second S/D contact portion of the local interconnect (provided the first second S/D region is abutted) or the second second S/D contact portion of the local interconnect (provided the second second S/D region is abutted).

In case the transistor feature is a second gate structure, the local interconnect and the cut-out in the gate structure allows the first first S/D region and the second gate structure to be interconnected by the local interconnect. This may be useful to realize circuit cells implementing a function (e.g. logic function, storage function) requiring a source or drain of a first transistor to be coupled to a second gate structure of a second transistor, such as an inverter or buffer. The second portion of the local interconnect abutting the second gate structure may in this case interchangeably be referred to as the gate contact portion of the local interconnect.

In some embodiments, the cut-out is formed in the gate structure at a position between the first and second active regions. The cut-out may thus be offset from the respective first channel regions, i.e. where the gate structure overlaps the first and second regions of the first and second active regions. The cut-out may thus be provided without affecting the thickness of the gate material at the first channel regions, and without requiring any modification of the respective channel structure (e.g., a fin or one or more channel nanosheets) extending through the first and second first channel regions. The cut-out may in particular be formed at a position approximately mid-way between the first and second active regions.

In some embodiments, the cut-out is configured as a downwardly extending recess in a top side of the first gate structure. The intermediate portion of the local interconnect may hence in a sense be sunken into the first gate structure from above. This may facilitate fabrication since the cut-out may be formed in a straightforward fashion, e.g., by partially etching back the top side of the gate structure from above, and subsequently forming the local interconnect to extend therethrough.

In some embodiments, the intermediate portion of the local interconnect does not extend above a level of the top side of the first gate structure. The intermediate portion of the local interconnect may hence be fully sunken into the first gate structure. The intermediate portion may thus be provided without adding to the vertical extension of the circuit cell, and without introducing any congestion for other interconnects. This limited vertical extension may apply to the local interconnect as a whole, i.e. also its first and second portions in addition to the intermediate portion. The term "vertical" is herein used to refer to a direction or dimension parallel to a normal direction to the footprint of the circuit cell (or equivalently frontside of the substrate).

In some embodiments, the intermediate portion of the local interconnect may instead comprise a lower portion extending through the cut-out and an upper portion extending above a level of the top side of the first gate structure. The intermediate portion may hence be only partially sunken into the first gate structure. Providing an upper portion extending vertically above the top side of the gate structure allows the vertical dimension of the intermediate portion, and hence its resistance, to be tuned independently from the vertical extension of the gate structure.

In some embodiments, the cut-out is configured as an upwardly extending recess in a bottom side of the first gate structure. The gate structure may hence in a sense bridge the intermediate portion of the local interconnect. The local interconnect may thus be provided without adding to the vertical extension of the circuit cell, and without introducing any congestion for other interconnects provided the first gate structure.

In some embodiments, the intermediate portion extends along a curvilinear and/or diagonal path between the first portion of the local interconnect.

Typically, the second active region may comprise a second first S/D region located at the first side of the first gate structure and directly opposite the first first S/D region. The semiconductor device may comprise a second local interconnect in the form of a first second S/D contact abutting the second first S/D region. The provision of the intermediate portion of the (first) local interconnect may be associated with extending the local interconnect, from its first portion, in the height direction, towards the first second S/D contact. This may make it challenging to ensure a sufficient spacing in the local interconnect level, between the local interconnect and the first second S/D contact.

However, arranging the intermediate portion to extend along a curvilinear and/or diagonal path may facilitate ensuring a sufficient spacing between the local interconnect and the first second/SD contact, compared to providing the local interconnects with a conventional rectilinear / Manhattan-type layout.

In some embodiments, the intermediate portion may additionally or alternatively extend along a curvilinear and/or diagonal path between the cut-out in the first gate structure and the second portion of the local interconnect. As may be appreciated, the preceding discussion may apply correspondingly to the extension of the intermediate portion at the second side of the first gate structure, in particular in a case where the second portion of the (first) local interconnect abuts a transistor feature in the form of a second S/D region. In this case, a curvilinear and/or diagonal layout of the intermediate portion may facilitate ensuring a sufficient spacing between the local interconnect and a second first S/D contact (if the abutted transistor feature is a second second S/D region) or a second second S/D contact (if the transistor abutted feature is a second first S/D region).

A curvilinear and/or diagonally extending intermediate portion may in particular be combined with embodiments wherein the cut-out is formed in the gate structure at a position between the first and second active regions.

In some embodiments, the first channel region of the first active region (the first first channel region) belongs to a first transistor of a first transistor type and the first channel region of the second active region (the second first channel region) belongs to a first transistor of a second transistor type, wherein the first transistor type is an n-type transistor and the second transistor type is a p-type transistor, or vice versa.

The cut-out may thus be provided in a common gate structure shared by a CMOS transistor pair, to allow horizontal signal routing across the common gate structure. The term "n-type transistor" herein refers to an n-channel metal oxide semiconductor field-effect transistor (nFET), and "p-type transistor" herein refers to a p-channel metal oxide semiconductor field-effect transistor (pFET).

In some embodiments, the transistor feature is a second gate structure of the circuit cell, consecutive to and parallel to the first gate structure, and wherein the local interconnect further comprises a third portion abutting a first S/D region of the second active region (second first S/D region) disposed directly opposite the first S/D region of the first active region (first first S/D region). The first first and second first S/D regions of the first and second transistors (the CMOS transistor pair) may thus be connected horizontally across first gate structure to a second gate structure. This may be useful to realize a circuit cell implementing an inverter or buffer. The third portion of the local interconnect abutting the second first S/D region may be interchangeably referred to as the second first S/D contact portion of the local interconnect.

In some embodiments, the first and third portions of the local interconnect extend to join with the intermediate portion at a location at the first side of the first gate structure and between the first and second active regions. The local interconnect may hence have a substantially T-shaped layout, to interconnect the first first and second first S/D regions and provide a horizontally routed signal path across the first gate structure.

In some embodiments, the second gate structure extends continuously to overlap a respective second channel region of each of the first and second active regions (i.e., a first second channel region and a second second channel region), wherein the second first channel region belongs to a second transistor of the first transistor type and the second second channel region belongs to a second transistor of the second transistor type. The first first and second first S/D regions may thus be connected to a second gate structure shared by a second CMOS transistor pair provided along the first and second active regions.

In some embodiments, the first transistors (the first transistor of the first transistor type and the first transistor of the second transistor type) are configured as a first inverter pair of the circuit cell and the second transistors (the second transistor of the first transistor type and the second transistor of the second transistor type) are configured as a second inverter pair of the circuit cell. The first S/D regions of the first inverter pair may hence be connected across the first gate structure to the second gate structure of the second inverter pair. This may be useful to realize a circuit cell implementing cascaded inverters, as in a logic buffer.

In some embodiments, the transistor feature is a second S/D region of the second active region (second second S/D region). This allows interconnecting S/D regions of the first and second active regions on opposite sides of the first gate structure.

In some embodiments, the second second S/D region belongs to the first transistor of the second transistor type.

Hence, the first first S/D region of the first transistor of the first transistor type (e.g., p- or n-type) may be connected across the shared first gate structure to the second second S/D region of the first transistor of the second transistor type (e.g., n- or p-type). This type of horizontal S/D-to-S/D interconnection across the first gate structure and between the first and second active regions may be useful to realize logical gates such as the NAND or NOR gate.

In some embodiments, each circuit cell further comprises a second gate structure consecutive to and parallel to the first gate structure, wherein the transistor feature is a second S/D region of the first or second active region located past the second gate structure, and wherein the intermediate portion of the local interconnect extends between the first and second portions through the cut-out formed in the first gate structure and a cut-out formed in the second gate structure.

The local interconnect may hence be used to horizontally route a signal across two consecutive gate structures. This may be useful to implement circuit cells where S/D regions on opposite sides of a pair of first and second gate structures are to be interconnected, while the S/D regions of the first and active regions between the first and second gate structures are to be skipped or bypassed.

### BRIEF DESCRIPTION OF THE DRAWINGS

These and other aspects of the present invention will now be described in more detail, with reference to the appended drawings.
Fig. 1 schematically shows a vertical layout of a semiconductor device.
Fig. 2 schematically shows a top-down view of a layout of a semiconductor device.
Fig. 3a-c show various implementations of a cut-out in a gate structure and an intermediate portion of a local interconnect.
Fig. 4 schematically shows a circuit cell comprising a local interconnect according to an example embodiment.
Fig. 5 schematically shows a circuit cell comprising a local interconnect according to a further example embodiment.
Fig. 6 schematically shows a circuit cell comprising a local interconnect according to a further example embodiment.
Fig. 7 schematically shows a circuit cell comprising a local interconnect according to a further example embodiment.
Fig. 8 is a circuit diagram of a logic buffer.
Fig. 9 schematically shows an example embodiment of a circuit cell implementing the logic buffer of Fig. 8.
Fig. 10 is a circuit diagram of a NAND gate.
Fig. 11 schematically shows an example embodiment of a circuit cell implementing the NAND gate of Fig. 10.
Fig. 12 is a circuit diagram of a NOR gate.
Fig. 13 schematically shows an example embodiment of a circuit cell implementing the NOR gate of Fig. 12.

### DETAILED DESCRIPTION

Implementations and examples of semiconductor devices and circuit cells will below be described with reference to the drawings.

The drawings are only schematic and the relative dimensions of illustrated elements, such as layers or other structures, may be exaggerated and not drawn to scale. Rather the dimensions may be adapted for illustrational clarity and to facilitate understanding. When present in the figures, the indicated axes X, Y and Z point in a first cell direction (horizontal direction), a second cell direction (height direction), and a vertical direction, respectively.

Terms indicating relative vertical arrangement or orientations of elements, such as "top", "upper", "bottom", "lower", "downwardly", "upwardly", and the like, are to be understood in relation to the vertical direction Z.

It is to be noted that when an element (e.g. a layer or other structure) is referred to as being "on" another element, it can be directly on the other element or on one or more intermediate elements on the other element. Conversely, when an element is referred to as being "directly on" another element, there is no intermediate element and the element is thus formed in physical contact or abutment with the other element.

It is further to be noted that terms such as "first" and "second" etc. with reference to elements (e.g. layers or other structures) or, as the case may be, process steps are used herein only as labels to facilitate distinguishing between different elements, and need not necessarily imply that such elements or process steps are arranged or performed in that particular order, unless stated otherwise.

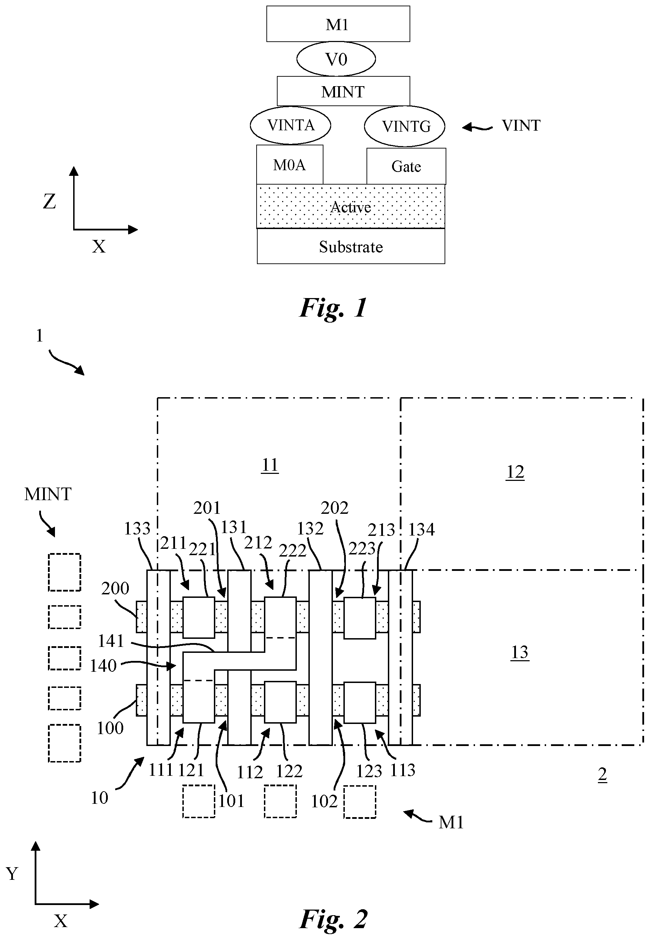

Fig. 1 is a schematic depiction of a vertical layout of the first few stacked layers / levels of a substrate portion and an overlying interconnect structure of an example semiconductor device.

The first layer over the substrate is as shown the "Active" layer. The Active layer comprises the active regions of the semiconductor device. The term "active region" as used herein refers to a feature or pattern of semiconductor material (e.g., elongated and parallel to the horizontal direction X) and comprising a number of S/D regions and channel regions alternating the S/D regions. The S/D regions may comprise semiconductor material bodies, e.g., epitaxially grown, doped with an n- or p-type dopant. The channel regions may comprise a channel structure of a semiconductor channel material, extending between and connecting the semiconductor material bodies of the surrounding S/D regions. The channel structure may be fin-shaped (e.g., to form a finFET transistor) or comprise a vertical stack of channel layers in the form of nanowires or nanosheets (e.g., to form a gate-all-around transistor). The Active layer forms part of the front-end-of-line (FEOL) of the semiconductor device.

The next layers above and consecutive to the active layer are the local interconnect layer "M0A" (interchangeably local contact layer) and the gate layer "Gate".

The Gate layer comprises the gate structures of the semiconductor device (e.g., the gate electrode). The gate structures extend in the cell height direction Y (into the XZ plane in Fig. 1) to overlap the channel regions of the active regions of the Active layer. Fig. 1 shows the Gate layer in a schematic and simplified manner as a single layer, but the Gate layer (i.e., the conductive gate body / gate electrode of each gate structure) may typically comprise one or more gate metal layers (e.g., work function metal(s) and gate fill metal).

The M0A layer (which also may be referred to as a local contact layer) comprises the local interconnects (e.g., the S/D contacts) of the circuit cell. Fig. 1 shows the M0A layer in a schematic and simplified manner as a single layer, but the M0A layer may typically comprise one or more local interconnect or contact metal layers. For example, the M0A layer may comprise (at least) two metal layers: a bottom layer ("contact-to-active" or "trench silicide") and a top or "plug" layer (e.g. of TiN, Co, Ru and/or W).

As shown in Fig. 1, the M0A and Gate layers occupy a shared vertical space of the semiconductor device. In other words, the M0A and Gate layers are overlapping or co-located along the vertical dimension Z. In Fig. 1, the M0A and Gate layers are shown to span a same vertical space, and thus present a complete mutual overlap along the vertical dimension Z. However, as may be appreciated by the skilled person, this is an idealized depiction and the actual conductive structures of the Gate layer (the gate electrodes) and M0A layer (the local interconnects and S/D contacts) may have somewhat different vertical dimensions so as to define only a partial mutual overlap along the vertical dimension Z. As a non-limiting example, the gate electrode may protrude some vertical distance above the S/D contacts, or vice versa. Additionally, or alternatively, a bottom portion of the gate electrode may be located vertically below a bottom portion of the bottom / contact-to-active layer of the M0A layer (e.g., in the case of a finFET or gate-all-around transistor). In any case, the gate structures of the Gate layer may block a horizontal extension (along the X direction) of the local interconnects of the M0A layer.

The next layer above and consecutive to the M0A and Gate layers is the first metal via layer VINT. The VINT layer is the first (as in bottom-most) metal via layer, counted from the Active layer (or equivalently the substrate). The VINT layer comprises contact vias VINTA landing on the local interconnects of the M0A level and gate vias VINTG landing on the gate structures of the Gate level.

The next layer above and consecutive to the VINT layer is the first metal line layer MINT. The Mint layer is arranged on top of and in abutment with the contact vias VINTA and gate vias VINTG of the VINT layer. The MINT layer is the first (as in bottom-most) metal line layer, counted from the Active layer. The metal lines (wires) of the MINT layer may form a pattern of parallel metal lines extending in the horizontal direction X.

While the terms "VINT" and "MINT" are used herein to refer to the bottom-most metal via and metal line layers, respectively, other terminologies exist in the art. For instance, the VINT and MINT layers are sometimes instead denoted V0 and M0. Successive metal via layers may in this case share numbering with the consecutive metal line layer (e.g., V1 and M1, V2 and M2, etc.).

The next layer consecutive to the M0 layer is the second metal via layer V0. The V0 layer is the second (as in second bottom-most) metal via layer, counted from the Active layer. The V0 level comprises vias landing on the metal lines of the VINT layer.

The next layer consecutive to the V0 layer is the second metal line layer M1. The M1 layer is arranged on top of and in abutment with the V0 layer. The M1 layer is the second (as in second bottom-most) metal line layer, counted from the Active layer. The metal lines (wires) of the M1 layer may form a pattern of parallel metal lines extending in the height direction Y (into the XZ plane in Fig. 1).

While not shown in Fig. 1, additional metal via layers (VX) and metal line layers (MX+1) may be stacked on top of the M1 layer (e.g., V1/M2/V2/M3...).

More generally, the vertical layout of the semiconductor device may be partitioned into the FEOL, the MOL (sometimes also denoted "MEOL") and the BEOL. The FEOL may comprise at least the Active layer, optionally also the Gate layer. The MOL may comprise at least the M0A layer, optionally also the Gate layer (if not comprised in the FEOL), and optionally also the VINT and MINT layers. The BEOL may comprise at least the V0 and M1 layers. However, the specific association between the layers and the FEOL, MOL and BEOL may vary, e.g., depending on the technology node and at what stage of the IC fabrication the various structures are formed. For instance, in some contexts, the MINT layer may be comprised in the BEOL rather than in the MOL.

An example embodiment of a semiconductor device 1 (e.g., an IC device) will now be described with reference to Fig. 2 showing a top-down view of the planar layout of the semiconductor device 1.

To facilitate understanding of the vertical layout of the semiconductor device 1, reference will in the following further be made to the layers of the vertical layout of Fig. 1. It is here to be understood that the specific labels used in Fig. 1 (e.g., M0A, VINT, MINT, etc.) are not to be construed as limiting the applicability to implementations wherein such specific labels are used for the layers of the device. Rather, in the following, "Active layer" may refer to a layer comprising the active regions, "M0A layer" may refer to a layer comprising the local interconnects or contacts (e.g., the S/D contacts), "Gate layer" may refer to a layer comprising the gate structures, "VINT layer" may refer to a first/bottom-most metal via layer, "MINT layer" may refer to a first/bottom-most metal line layer, "V0 layer" may refer to a second metal via layer consecutive to the MINT layer, and "M1" may refer to a second metal line layer consecutive to the V0 layer, etc.

The semiconductor device 1 comprises a plurality of circuit cells 10, 11, 12, 13. The dash-dotted lines indicate the boundaries of the circuit cells 10, 11, 12, 13. Reference sign 2 schematically indicates a substrate 2 of the semiconductor device 1, extending underneath and supporting the circuit cells 10, 11, 12, 13. The main plane of extension of the substrate 2 is in Fig. 2 parallel to the XY-plane. The substrate 2 may be a conventional substrate, suitable for CMOS circuits and semiconductor device processing. The substrate 2 may for instance be a Si substrate, a Ge substrate or a SiGe substrate. Other non-limiting examples include a silicon-on-insulator (SOI) substrate, a GeOI substrate or a SiGeOI substrate.

The circuit cells 10, 11, 12, 13 are arranged in a regular array of a plurality of rows and columns. While Fig. 2 only shows an array of two-by-two circuit cells 10, 11, 12, 13, the semiconductor device 1 may typically comprise a considerably larger number of circuit cells, each implementing a certain circuit function, e.g., logical or storage. The circuit cells 10, 11, 12, 13 may for example be standard cells selected from a standard cell library.

Fig. 2 shows the layout of the circuit cell 10, which will be discussed in detail in the following. However, it is to be understood that the further circuit cells 11, 12, 13 may have an identical, similar or different layout, depending on their respective functions. As an example, the circuit cells 10, 11, 12, 13 may implement like functions, wherein the circuit cells 10, 13 may have identical layouts, and the circuit cells 11,12 have layouts corresponding to the circuit cells 10, 13 but mirrored (flipped) along the second cell direction Y such that common routing resources (e.g., VSS or VDD power rails) located along horizontal cell boundaries may be shared between neighboring circuit cells.

The circuit cell 10 comprises first and second active regions 100, 200 extending in parallel in the first cell / horizontal direction X and spaced apart in the second cell / height direction Y. The first active region 100 comprises a first S/D region 111 (interchangeably first first S/D region 111), a second S/D region 112 (interchangeably first second S/D region 112), and a first channel region 101 (interchangeably first first channel region 101) intermediate the first and second S/D regions 111, 112. Correspondingly, the second active region 200 comprises a first S/D region 211 (interchangeably second first S/D region 211), a second S/D region 212 (interchangeably second second S/D region 212), and a first channel region 201 (interchangeably second first S/D region 201) intermediate the first and second S/D regions 211, 212.

The circuit cell 10 further comprises a first gate structure 131 arranged in the Gate layer and extending in the height direction Y, transverse to the horizontal direction X. The first gate structure 131 extends continuously between the first and second active regions 100, 200 to overlap the first channel region 101 of the first active region 100 and the first channel region 201 of the second active region 200. By a "continuous" extension of a gate structure is herein meant that the body of the gate structure, more specifically the gate electrode extends continuously, i.e., interrupted, between the first and second active regions 100, 200. The first gate structure 131 is hence common to, or shared by, the first and second active regions 100, 200.

The first channel regions 101, 201 are arranged directly opposite each other as seen along the height direction Y. The first S/D regions 111, 211 are arranged on a first side of the gate structure 131, directly opposite each other as seen along the height direction Y. The second S/D regions 111, 211 are arranged on an opposite second side of the first gate structure 131, directly opposite each other as seen along the height direction Y.

As further shown in Fig. 2, the first and second active regions 100, 200 may comprise a respective (first or second) third S/D region 113, 213, and a respective (first or second) second channel region 102, 202.

The circuit cell 10 may further comprise a second gate structure 132 arranged in the Gate layer and extending in the height direction Y parallel to the first gate structure 131. The second gate structure 132 may as shown extend continuously between the first and second active regions 100, 200 to overlap the second channel region 102 of the first active region 100 and the second channel region 202 of the second active region 200. The second gate structure 132 may hence be common to, or shared by, the first and second active regions 100, 200.

The second channel regions 102, 202 are arranged directly opposite each other as seen along the height direction Y. In addition to being arranged on the second side of the first gate structure 131, the second S/D regions 111, 211 are arranged on a first side of the second gate structure 132. Correspondingly, the third S/D regions 113, 213 are arranged on an opposite second side of the second gate structure 132, and directly opposite each other as seen along the height direction Y.

In the schematic view of Fig. 2, the gate structures 131, 132 are shown to terminate at the boundaries of the circuit cell 10. One or more of the gate structures may however, depending on the specific circuit implementation, extend further into one or more neighboring circuit cells to overlap channel regions of corresponding active regions thereof, such as one or more active regions of the circuit cell 11.

The circuit cell 10 may as shown comprise additional gate structures, such as gate structures 133, 134 arranged along opposite boundaries of the circuit cell 10. Such edge or boundary gate structures 133, 134 may typically be configured as dummy gates.

Further shown to the left-hand side of the circuit cell 10 are schematic indications of routing tracks of the first metal line layer MINT of the interconnect structure of the semiconductor device 1 overlying the circuit cells. The routing tracks of the MINT layer ("MINT routing tracks") extend in parallel in the horizontal direction X. The shown MINT routing tracks are associated with the circuit cell 10, and with any further circuit cells along the same row, e.g., the circuit cell 13 in the illustrated example. A corresponding set of MINT routing tracks may be associated with each respective row of circuit cells. The circuit cell 10 is associated with five MINT routing tracks. The two edge tracks disposed along the horizontal cell boundaries of the circuit cell 10 may as shown be of a double line width (along the Y-direction) to the three non-edge routing tracks, and further be shared with neighboring circuit cells across the horizontal cell boundaries. The circuit cell 10 may hence define a 4.5 track height cell. As a short hand, the routing tracks may in the following be denoted, in the order they are shown in Fig. 2, from top to bottom, an upper edge track, a first off-center track, a center track, a second off-center track, and a lower edge track. In some implementations, the edge tracks may be configured as backside or buried routing tracks and hence not be comprised in the MINT layer, for reduced routing congestion in the MINT layer.

Below the circuit cell 10 in Fig. 2 are indicated routing tracks of the second metal line layer M1 of the interconnect structure. The routing tracks of the M1 layer ("M1 routing tracks") extend in parallel in the height direction Y. The shown M1 routing tracks are associated with the circuit cell 10, and with any further circuit cells along the same column, e.g., the circuit cell 11 in the illustrated example. A corresponding set of M1 routing tracks may be associated with each respective column of circuit cells.

Metal lines arranged in any given MINT routing track may be coupled to a gate, a local interconnect, such as a S/D contact, of the local interconnect level of the circuit cell 10 by a via (in the VINT layer) extending vertically between the metal line and the local interconnect. Meanwhile, a metal line arranged in any given M1 routing track may be coupled to a crossing metal line in any MINT routing track by a via (in the V0 layer) extending vertically between the metal lines of the M1 and MINT layers.

As per se is known to the skilled person, a metal line arranged in any given MINT or M1 routing track need not extend along the full width or height dimension of the associated circuit cell but need only be disposed to define an overlap with respect to the structures that are to be interconnected, e.g., a MINT metal line, a gate structure, or a S/D contact or other a local interconnect. Further, some MINT or M1 routing tracks may even be unused, depending on the routing requirements of the specific circuit cell implementation.

The circuit cell 10 further comprises a set of local interconnect or contact structures 121-123, 140, 141, 221-223 arranged in the M0A layer. As shown in Fig. 2, the circuit cell 10 comprises a local interconnect 140. The local interconnect 140 is configured to couple the first S/D region 111 (at the first side of the first gate structure 131) to a transistor feature formed by the second S/D region 212 (at the second side of the first gate structure 131). The local interconnect 140 will be described in further detail below. The further S/D regions (e.g., S/D regions 112, 113, 211, 213) of the circuit cell 10 may as shown be abutted with respective S/D contacts 122, 123, 221, 223. The (second) first S/D region 211 may be abutted with a first S/D contact 221 (interchangeably second first S/D contact 221). The (first) second S/D region 112 may be abutted with a second S/D contact 122 (interchangeably first second S/D contact 122). The (first) third S/D region 113 (if present) may be abutted with a third S/D contact 123 (interchangeably first third S/D contact 123). The (second) third S/D region 213 (if present) may be abutted with a third S/D contact 223 (interchangeably second third S/D contact 223). The S/D contacts 122, 123, 221, 223 may in turn be coupled to respective metal lines in the MINT and M1 layers using vias in the VINT and V0 layers.

Fig. 1 in conjunction with Fig. 2, readily illustrates the above discussed horizontal blockage of the S/D contacts. That is, while an S/D contact may be extended along the height direction Y, parallel to the gate structures, an extension along the horizontal direction X is blocked by the gate structures. Therefore, in a conventional implementation of a circuit cell wherein S/D regions on opposite sides of a gate structure are to be interconnected (such as the first S/D region 111 and the second S/D region 212 on the first and second sides of the first gate structure 131) the interconnection is routed vertically above the M0A and Gate layers using the VINT and MINT layers, possibly also using the V0 and M1 layers, thus adding to the routing congestion and complexity above the circuit cell.

The local interconnect 140 of the circuit cell 10 as shown in Fig. 2 mitigates this issue by enabling a direct coupling between the first and second S/D regions 111, 212 confined to the M0A layer. To achieve this, the local interconnect 140 comprises as shown a first S/D contact portion 121 (interchangeably first first S/D contact or contact portion 121) abutting the first S/D region 111, a second S/D contact portion 222 (second second S/D contact or contact portion 222) abutting the second S/D region 212, and an intermediate portion 141 extending between the first and second S/D contact portions 121, 222 through a cut-out formed in the first gate structure 131, at a position between the first and second active regions 100, 200. The intermediate portion 141 of the local interconnect 140 may thus extend between and interconnect the first and second S/D contact portions 121, 222. The dashed horizontal lines within the local interconnect 140 schematically indicates the sub-division of the local interconnect 140 into the respective portions 121, 222, 141. However, as may be appreciated, since the local interconnect 140 forms a continuous conductive / metal body, the precise extent of the respective portions 121, 222, 141 is somewhat arbitrary.

For example, the first channel region 101 and the first and second S/D regions 111, 112 of the first active region 100 may belong to a first transistor of a first transistor type (e.g. an nFET or pFET) and the first channel region 201 and the first and second S/D regions 211, 212 of the second active region 200 may belong to a first transistor of a second transistor type opposite the first transistor type (e.g. a pFET if the first transistor type is nFET or an nFET if the first transistor type is pFET). The nFET and pFET transistors may hence define a CMOS pair with S/D regions disposed on opposite sides of the shared gate structure 131 of the CMOS pair being interconnected by the local interconnect 140.

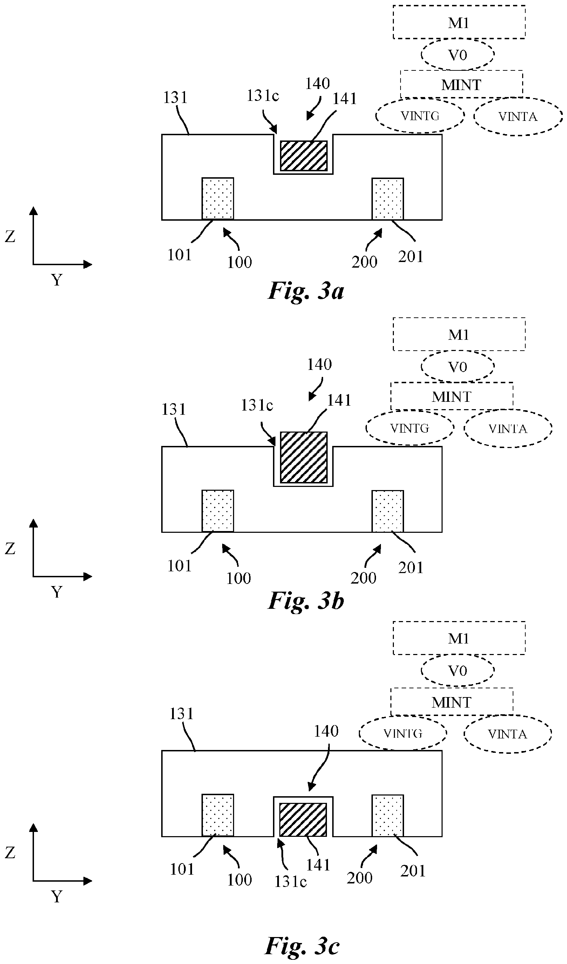

Various implementations of the local interconnect 140 and the cut-out in the first gate structure 131 are shown in Fig. 3a-c. A common feature of the illustrated implementations is that the cut-out 131c is formed in the gate structure 131, at a position between the first and second active regions 100, 200, more specifically between their respective channel regions 101, 201. The cut-out 131c extends through the gate structure 131 along the vertical direction Z, in particular through the gate electrode (e.g., one or more gate metal layers thereof), however only partially so as not to cut the gate structure 131 into two disconnected or discontinuous parts. Accordingly, a portion of the gate structure 131 (a gate electrode portion) remains underneath (as in Fig. 3a)-b or above (as in Fig. 3c) the gate cut 131c such that the gate structure 131 (gate electrode) extends continuously between the first and second active regions 100, 200. While not individually shown in the figures, the cut-out 131c may in Fig. 3a-b further extend through an insulating gate cap layer of the gate structure, which may be present on top of the gate electrode.

Fig. 3a shows a first implementation wherein the cut-out 131c is configured as a downwardly extending recess (i.e., vertically, along the Z direction) in a top side of the first gate structure 131. The intermediate portion 141 of the local interconnect 140 extends through the cut-out 131c along the horizontal direction X (i.e. which is transverse to the YZ plane in Fig. 3a). In Fig. 3a, the intermediate portion 141 does not extend above a level of the top side of the first gate structure 131. A depth dimension of the cut-out 131c (along the Z direction) thus exceeds a vertical dimension (along the Z direction) of the intermediate portion 141 and the intermediate portion 141 is fully sunk into the gate structure 131. The intermediate portion 141 may thus be fully accommodated within the vertical dimension of the Gate layer, so as not to protrude above the gate structure 131 and the Gate layer. This may apply correspondingly to the local interconnect 140 in its entirety. That is, also the first and second S/D contact portions 121, 222 may be configured to not extend above the level of the top side of the first gate structure 131, or above the Gate layer. The dashed outline interconnect structure in Fig. 3a, schematically shows the vertical extension of the gate structure 131 and local interconnect 140 relative the VINT, MINT, V0 and M1 layers.

Fig. 3b shows a second implementation wherein the cut-out 131c like in Fig. 3b is configured as a downwardly extending recess in the top side of the first gate structure 131, but wherein the intermediate portion 141 of the local interconnect 140 comprises a lower portion extending through the cut-out 131c and an upper portion extending above a level of the top side of the first gate structure 131. Hence, the depth dimension of the cut-out 131c (along the Z direction) is less than the vertical dimension (along the Z direction) of the intermediate portion 141 such that the intermediate portion 141 is only partially sunk into the gate structure 131. This configuration may for instance be used in circuit cell implementations wherein the top surfaces of the S/D contacts of the M0A layer are located at a level above the level of the top surface of the gate structures of the Gate layer. As shown, the upper portion of the intermediate portion 141 may thus protrude into the VINT layer. Hence, the M0A layer and VINT layer may present a partial vertical overlap.

Fig. 3c shows a third implementation wherein the cut-out 131c is configured as an upwardly extending recess (i.e., vertically, along the Z direction) in a bottom side of the first gate structure 131. The gate structure 131 hence bridges the intermediate portion 141 of the local interconnect 140. In the illustrated example, a bottom side of the intermediate portion 141 is substantially co-planar with a the bottom side of the first gate structure 131. This does however not generally need to be the case and the relative vertical locations of the bottom sides of the first gate structure 131 and the intermediate portion 141 may also be different. For instance, the bottom side of the gate structure 131 may be arranged at a lower level than the bottom side of the intermediate portion 141.

A semiconductor device comprising a local interconnect 140 according to the first, second or third implementations may be fabricated employing conventional CMOS device fabrication approaches, but supplemented with additional steps for forming the local interconnect 140 and the cut-out 131c. Conventional CMOS device fabrication approaches may generally comprise FEOL processing and BEOL processing. The BEOL processing may optionally be preceded by MOL processing. The FEOL processing may for instance comprise active patterning, shallow-trench isolation (STI) formation, gate patterning and S/D epitaxy. The MOL and/or BEOL processing may comprise forming local interconnects of the M0A layer. The BEOL processing may further comprise metal via and metal line formation (e.g., using damascene- and/or direct metal etch-based approaches).

A cut-out 131c as shown in Fig. 3a-b may for example be formed by introducing a further mask for the cut-out and performing a partial vertical etch back of the top surface of the gate structure prior to forming the local interconnects of the M0A layer. The gate structure may subsequently be covered with interlayer dielectric (ILD). M0A trenches (i.e., trenches for the local interconnects / contacts of the M0A layer) may be patterned in the ILD, including a trench for the intermediate portion 141 of the local interconnect 140. The trenches may then be filled with the M0A layer metal.

A cut-out 131c as shown in Fig. 3c may for example be formed by, prior to gate patterning, forming a place-holder feature of a sacrificial material (e.g. an oxide or nitride being etch selective to the gate material) at a location between the first and second active regions 100, 200 where the cut-out 131c is desired. The gate structure may hence be formed on top of the place-holder feature. The place-holder feature may subsequently be removed (i.e., selectively to the gate material) when patterning the M0A trenches, e.g. using a suitable selective isotropic etch. A cut-out 131c in the shape of a tunnel may thereby be formed through the gate structure 131, which may be filled with the M0A metal to form the intermediate portion 141 of the local interconnect 140. Alternatively, the local interconnect 140 may be formed prior to forming the gate structure 131, so that when the gate structure 131 is to be formed, the local interconnect 140 is already present wherein the gate structure 131 may be formed across and over the local interconnect 141.

The above-discussed processing approaches are however merely non-limiting examples, and any other process techniques allowing forming of a cut-out through a gate structure and forming of a local interconnect with an intermediate portion as disclosed herein may be employed.

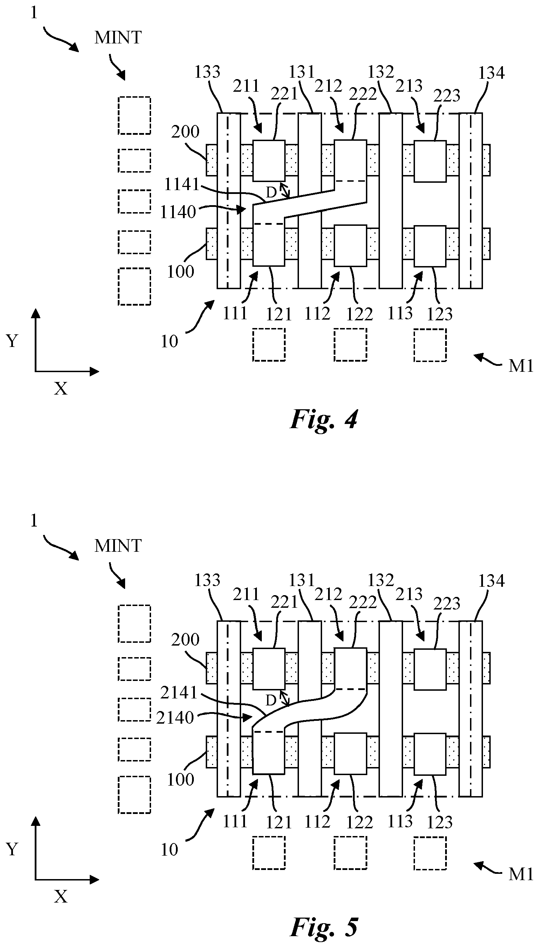

In connection with Fig. 2, a circuit cell 10 comprising a local interconnect 140 of a substantially rectilinear or Manhattan-type shape has been disclosed. Fig. 4 schematically shows a corresponding circuit cell 10 comprising a local interconnect 1140 according to a further example embodiment. The local interconnect 1140 is similar to the local interconnect 140 but differs in that the intermediate portion 1141 extends along a diagonal path between the first S/D contact portion 121 and the second S/D contact portion 222. A diagonal routing of the intermediate portion 1141 may facilitate ensuring a sufficient separation to adjacent local interconnects of the M0A layer, e.g., the spacing D to the first S/D contact 221 indicated in Fig. 4.

Fig. 5 schematically shows a circuit cell 10 corresponding to the circuit cell 10 in Fig. 2, but comprising a local interconnect 2140 of a further example embodiment, comprising an intermediate portion 2141 extending along a curvilinear (curved) path instead of a straight-line horizontal or diagonal path. A curvilinear routing of the intermediate portion 1142 may like the diagonal routing facilitate ensuring a sufficient separation to adjacent local interconnects of the M0A layer, e.g., the spacing D to the first S/D contact 221 indicated in Fig. 5.

A diagonal or curvilinear routing of the intermediate portion 1141 may be combined with any of the implementations shown in Fig. 3a-c.

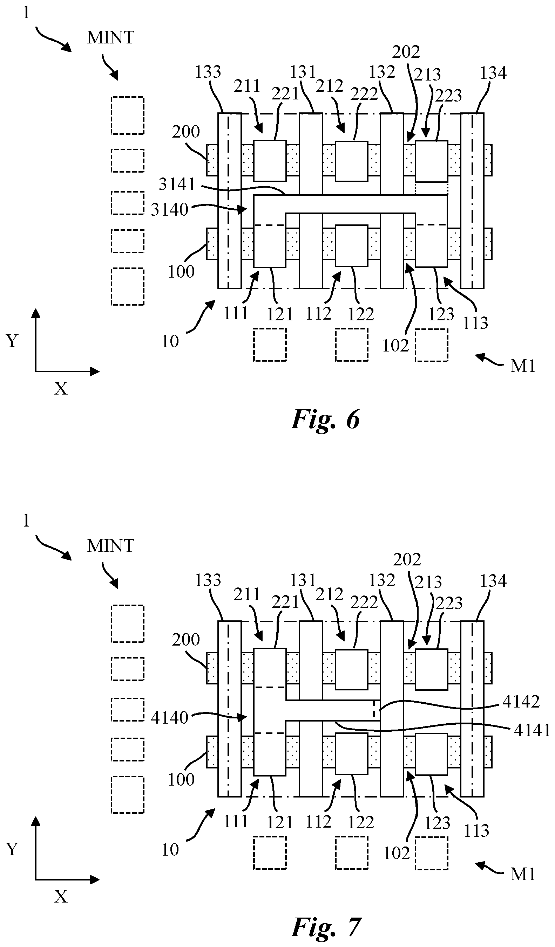

Fig. 6 schematically shows a circuit cell 10 corresponding to the circuit cell 10 in Fig. 2, but comprising a local interconnect 3140 of a further example embodiment. The local interconnect 3140 differs from the local interconnect 140 in that it is configured to interconnect a first S/D region on a first side of the first gate structure 131 and a second S/D region located past the second gate structure 132. Accordingly, the local interconnect 3140 comprises a first S/D contact portion 121 abutting the first S/D region 111, and a second S/D contact portion abutting a second S/D region. In Fig. 6, the S/D contact portion 123 defines the second S/D contact portion and the S/D region 113 located past the second gate structure 132 defines the second S/D region.

To enable the horizontal interconnection between the S/D regions 111 and 113, the second gate structure 132 is like the first gate structure 131 provided with a cut-out. The intermediate portion 3141 and the cut-outs in the first and second gate structures 131, 132 may be correspondingly configured, e.g. in accordance with either of Fig. 3a-c.

In Fig. 6, the local interconnect 3140 is configured to interconnect first and second S/D regions of the same active region 100. As indicated by the dotted connecting lines between the intermediate portion 3141 and the S/D contact 223, a corresponding approach may be used to interconnect first and second S/D regions of the first and second active regions 100, 200.

While the local interconnect 3140 in Fig. 6 is of a Manhattan-type shape, the local interconnect 3140 may also be provided with a diagonal and/or curvilinear shape along at least a part of its length.

It is further contemplated that a corresponding approach may be adopted also in a circuit cell wherein the second gate structure is not consecutive to the first gate structure. That is, one or more intermediate gate structures may be present between the first and second gate structures. In this case, the local interconnect may be arranged to extend through corresponding cut-outs in the intermediate gate structures, in order to bridge the horizontal distance between, and thus interconnect, the first S/D contact portion located at the first side of the first gate structure and the second S/D contact portion located past the second gate structure.

In connection with Fig. 2 and 4-6, example embodiments of circuit cells 10 comprising a local interconnect configured to interconnect a first S/D region to a transistor feature formed by a second S/D region have been discussed. Fig. 7 schematically shows a corresponding circuit cell 10 comprising a local interconnect 4140 according to a further example embodiment, configured to interconnect a first S/D region and a transistor feature formed by a gate structure.

Accordingly, with reference to Fig. 7, the transistor feature is the second gate structure 132 of the circuit cell 10. The local interconnect 4140 comprises, like in the above discussed embodiments, a first portion 121, more specifically a first S/D contact portion 121, abutting the first S/D region 111 on the first side of the first gate structure 131. The local interconnect 4140 further comprises a second portion 4142 abutting the second gate structure 132, and an intermediate portion 4141 extending between the first S/D contact portion 121 and the second portion 4142, through the cut-out in the gate structure 131 (corresponding to cut-out 131c in Fig. 3a-c). The second portion 4142 of the local interconnect 4140 may as indicated in Fig. 7 be arranged as an end portion at the intermediate portion 4141.

The local interconnect 4140 thus enables a direct coupling between the first S/D region 111 and the second gate structure 132, routed exclusively using the M0A layer.

The local interconnect 4140 may as shown further comprise a third portion 221 abutting the (second) first S/D region 211. More specifically, in Fig. 7 the third portion 221 of the local interconnect 4140 is formed by a (second) first S/D contact or contact portion 221. The first and third portions 121, 221 may as shown extend to join the intermediate portion 4141 at a location at the first side of the first gate structure 131, between the first and second active regions 100, 200.

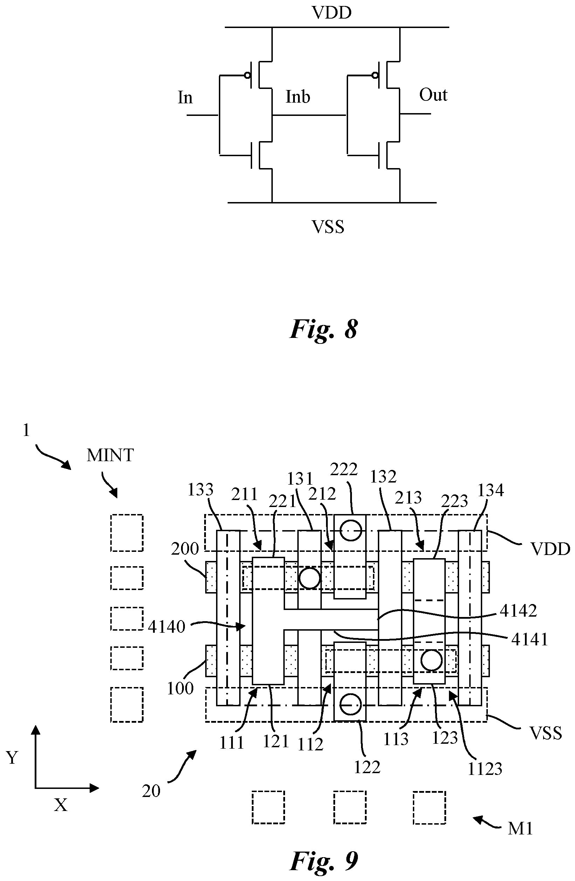

Fig. 8 is a circuit diagram of a logic buffer. The logic buffer comprises an input node coupled to a gate terminal of a first CMOS transistor pair comprising a first pull-up transistor (e.g. pFET) coupled to a VDD supply voltage and a first pull-down transistor (e.g. nFET) coupled to a VSS supply voltage (e.g., a reference voltage such as GND or a negative supply voltage). The first pull-up and pull-down transistors are interconnected at an internal node Inb. The internal node Inb is coupled to a gate terminal of a second CMOS transistor pair comprising a second pull-up transistor (e.g. pFET) coupled to the VDD supply voltage and a second pull-down transistor (e.g. nFET) coupled to the VSS supply voltage. The second pull-up and pull-down transistors are interconnected at an internal node Out, forming the output node of the logic buffer. The first CMOS pair is hence configured as a first inverter and the second CMOS pair configured as a second inverter connected in series with the first inverter, wherein the first inverter forms the input stage of the logic buffer and the second inverter forms the output stage of the logic buffer. The logic buffer may of course be extended to comprise any number of series connected inverters.

Fig. 9 schematically shows an example embodiment of a circuit cell 10 configured to implement the logic buffer of Fig. 8. As is apparent from Fig. 9, the circuit cell 10 has the same general layout as the circuit cell 10 of Fig. 7 and accordingly comprises the local interconnect 4140 comprising first, second and third portions 121, 4142, 221 abutting the (first) first S/D region 111, the second gate structure 132 and the (second) first S/D region 211, respectively, and the intermediate portion 4141 extending therebetween.

In this implementation, the first active region 100 defines an n-type region and the second active region 200 defines a p-type region. The first channel region 101 of the first active region 100 and the first and second S/D regions 111, 112 belongs to a first transistor of a first transistor type (a first nFET). The second channel region 102 of the first active region 100 and the second and third S/D regions 112, 113 belongs to a second transistor of the first transistor type (a second nFET). The first channel region 201 of the second active region 200 and the first and second S/D regions 211, 212 belongs to a first transistor of a second transistor type (a first pFET). The second channel region 202 of the second active region 200 and the second and third S/D regions 212, 213 belongs to a second transistor of the second transistor type (a second pFET).

Reference signs indicate optional gate structures 133, 134 which may be configured as dummy gates.

The first nFET and pFET, and the second nFET and pFET are configured as the first and second inverters of Fig. 8, respectively.

The first and second pFETs (more specifically the shared second S/D region 212) are coupled to the VDD supply voltage arranged along the upper edge track of the MINT layer (or as a buried or backside power rail) by the shared S/D contact 222 and a contact via of the VINT layer (or a via-to-BPR in the case of a buried or backside power rail) indicated by the rounded shape overlapping the S/D contact 222.

The first and second nFETs (more specifically the shared second S/D region 112) are coupled to the VSS supply voltage arranged along the lower edge track of the MINT layer (or as a buried or backside power rail) by the shared S/D contact 122 and a contact via of the VINT layer (or a via-to-BPR in the case of a buried or backside power rail) indicated by the rounded shape overlapping the S/D contact 122.

The internal node Inb of the first inverter and the connection between the internal node and the gate terminal of the second inverter shown in Fig. 8, is in Fig. 9 realized by the local interconnect 4140.

The first gate structure 131 (configured as the gate terminal of the first inverter) is coupled to the input signal line In arranged in the first off-center MINT track by a gate via in the VINT layer, indicated by the rounded shape at the crossing between the first off-center MINT track and the first gate structure 131.

The internal node Out of the second inverter forming the output of the logic buffer in Fig. 8, is in Fig. 9 realized by the shared S/D contact 1123 comprising S/D contact portions 123 and 223 abutting the third S/D regions 113, 213. The Out node is in turn coupled to an output signal line arranged in the second off-center MINT track by a contact via in the VINT layer, indicated by the rounded shape at the crossing between the second off-center MINT track and the shared S/D contact 1123.

The circuit cell 10 hence enables 4.5 track height implementation of the logic buffer shown in Fig. 8. The center MINT track may in this implementation be un-used. As a comparative example, a conventional standard circuit cell implementing a corresponding logic buffer would in contrast typically be realized as a 6 track height cell, employing the VINT/MINT and V0/M1 layers to route signals between the first S/D regions 111, 211 and the second gate structure 132, and to realize the interconnection of the third S/D regions 113, 213.

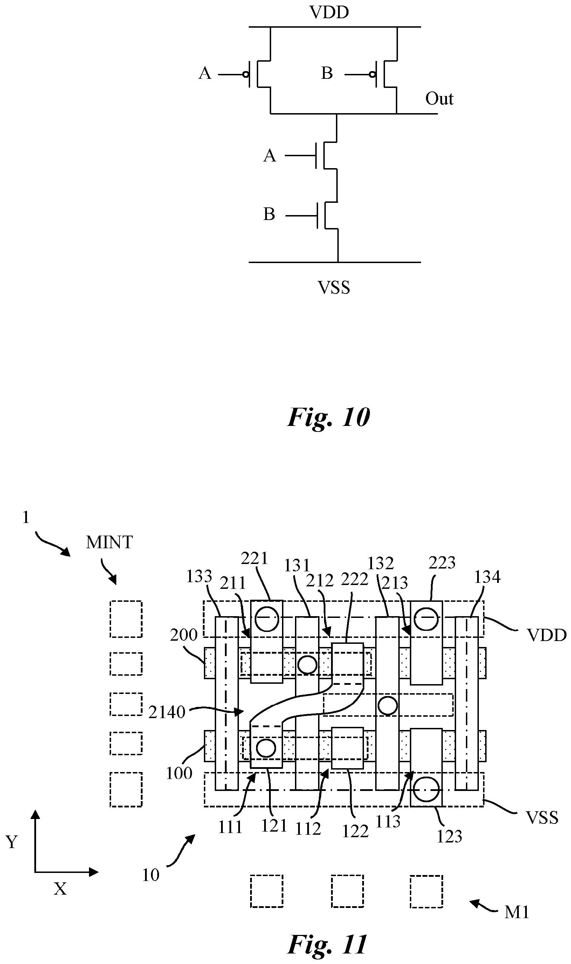

Fig. 10 is a circuit diagram of a NAND gate. The NAND gate comprises first and second input nodes A, B coupled to respective gates of a first and second pFET and a first and second nFET. The first and second pFETs are further coupled to a VDD supply voltage. The first and second second nFETs are coupled in series between the pFETs and a VSS supply voltage. The Out node forms the output node of the NAND gate.

Fig. 11 schematically shows an example embodiment of a circuit cell 10 configured to implement the NAND gate of Fig. 10. As is apparent from Fig. 11, the circuit cell 10 has the same general layout as the circuit cell 10 of Fig. 5 and accordingly comprises the local interconnect 2140 with the curvilinear intermediate portion 2141.

Like in Fig. 9, the S/D regions 111, 112, 113 and the channel regions 101, 102 of the first active region 100 belong to first and second nFET transistors, and the S/D regions 211, 212, 213 and the channel regions 201, 202 of the second active region 200 belong to first and second pFET transistors. The gate structures 133, 134 may be configured as dummy gates.

The first and second pFETs (more specifically the respective second S/D regions 211 and 213) are coupled to the VDD supply voltage arranged along the upper edge track of the MINT layer (or as a buried or backside power rail) by respective S/D contacts 221, 223 and a respective contact via of the VINT layer (or a via-to-BPR in the case of a buried or backside power rail) indicated by the rounded shape overlapping the S/D contacts 221, 223.

The second nFET (more specifically the third S/D region 113) is coupled to the VSS supply voltage arranged along the lower edge track of the MINT layer (or as a buried or backside power rail) by the S/D contact 123 and a contact via of the VINT layer (or a via-to-BPR in the case of a buried or backside power rail) indicated by the rounded shape overlapping the S/D contact 123.

The first gate structure 131 (configured as a common gate terminal of the first nFET and the first pFET) is coupled to the A input signal line arranged in the first off-center MINT track by a gate via in the VINT layer, indicated by the rounded shape at the crossing between the first off-center MINT track and the first gate structure 131.

The second gate structure 132 (configured as a common gate terminal of the second nFET and the second pFET) is coupled to the B input signal line arranged in the center MINT track by a gate via in the VINT layer, indicated by the rounded shape at the crossing between the center MINT track and the second gate structure 132.

The interconnection of the pFETs and nFETs is in Fig. 11 realized by the local interconnect 2140. The local interconnect 140 is in turn configured as the output node Out and is coupled an output signal line arranged in the second off-center MINT track by a contact via in the VINT layer, indicated by the rounded shape at the crossing between the second off-center MINT track and the local interconnect 2140 (e.g., its first S/D contact portion 121).

The implementation of the circuit cell 10 in Fig. 11 hence enables 4.5 track height implementation of the NAND gate shown in Fig. 10.

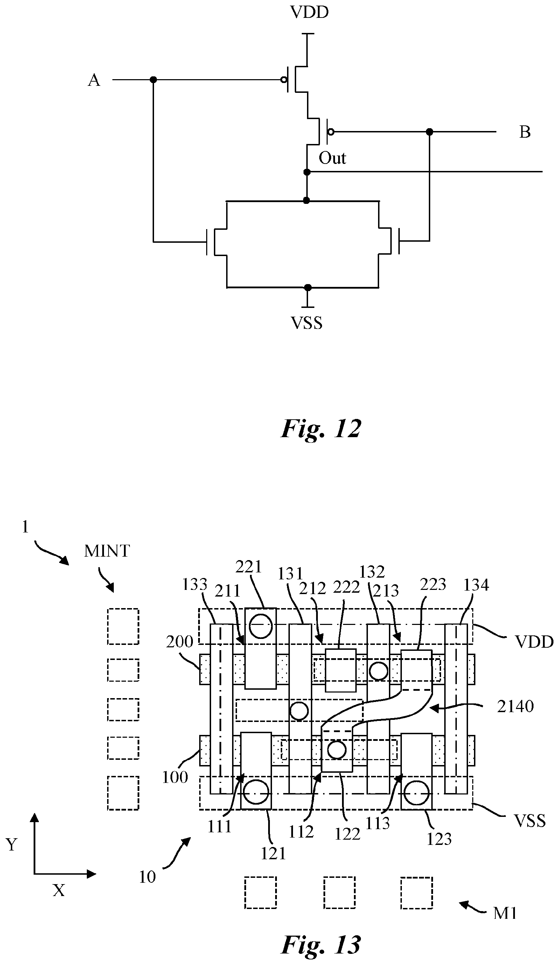

Fig. 12 is a circuit diagram of a NOR gate. The NOR gate comprises first and second input nodes A, B coupled to respective gates of a first nFET and a first pFET and a second nFET and a second pFET. The Out node forms the output node of the NOR gate.

Fig. 13 schematically shows an example embodiment of a circuit cell 10 configured to implement the NOR gate of Fig. 12. As is apparent from Fig. 13, the circuit cell 10 has the same general layout as the circuit cell 10 of Fig. 5 and accordingly comprises the local interconnect 2140 with the curvilinear intermediate portion 2141.

Like in Fig. 9, the S/D regions 111, 112, 113 and the channel regions 101, 102 of the first active region 100 belong to first and second nFET transistors, and the S/D regions 211, 212, 213 and the channel regions 201, 202 of the second active region 200 belong to first and second pFET transistors However in contrast to Fig. 9, the local interconnect 2140 is arranged to extend through the gate structure 132 to interconnect S/D regions 112 and 213. Hence, using a terminology consistent with the previous examples, in Fig. 13 the gate structure 132 is a first gate structure 132, the S/D region 112 is a (first) first S/D region 112 and the S/D region 213 is a (second) second S/D region 213. Further, the S/D region 113 is a (first) second S/D region 113, the S/D region 111 is a (first) third S/D region 111, the S/D region 222 is a (second) first S/D region 222 and the S/D region 211 is a (second) third S/D region 211. The gate structure 131 is a second gate structure 131. The gate structures 133, 134 may be configured as dummy gates.

The first gate structure 132 (configured as a common gate terminal of the first nFET and the first pFET) is coupled to the B input signal line arranged in the first off-center MINT track by a gate via in the VINT layer, indicated by the rounded shape at the crossing between the first off-center MINT track and the first gate structure 132.

The second gate structure 131 (configured as a common gate terminal of the second nFET and the second pFET) is coupled to the A input signal line arranged in the center MINT track by a gate via in the VINT layer, indicated by the rounded shape at the crossing between the center MINT track and the second gate structure 131.

The interconnection of the pFETs and nFETs is in Fig. 11 realized by the local interconnect 2140. The local interconnect 140 is in turn configured as the output node Out and is coupled an output signal line arranged in the second off-center MINT track by a contact via in the VINT layer, indicated by the rounded shape at the crossing between the second off-center MINT track and the local interconnect 2140 (e.g., its first S/D contact portion 122).

The implementation of the circuit cell 10 in Fig. 13 hence enables 4.5 track height implementation of the NOR gate shown in Fig. 12.

The person skilled in the art realizes that the present invention by no means is limited to the examples described above. On the contrary, many modifications and variations are possible within the scope of the appended claims. For example, as may be appreciated, the layout of the depicted example embodiments of circuit cells 10 is merely an example and a circuit cell may comprise an even greater number of S/D regions, channel regions and gate structures, as well as additional active regions, such as three parallel active regions or more, in cases where the specific circuit function implemented by the circuit cell so requires.

## Claims

1. A semiconductor device (1) comprising:
a plurality of circuit cells (10, 11, 12, 13), each circuit cell (10) comprising:
first and second active regions (100, 200) extending in parallel in a first cell direction;
at least a first gate structure (131) extending in a second cell direction transverse to the first cell direction to overlap a respective first channel region (101, 201) of each of the first and second active regions (100, 200), wherein the first gate structure (131) extends continuously between the first and second active regions (100, 200);
wherein the first active region (100) comprises a first S/D region (111) at a first side of the first gate structure (131), and the semiconductor device (1) further comprises a local interconnect (140, 4140) configured to couple the first S/D region (111) to a transistor feature at a second side of the first gate structure (131) opposite the first side,
wherein the transistor feature is a second S/D region (112, 212) of the first or second active region (100, 200), or a second gate structure (132) of the circuit cell (10), parallel to the first gate structure (312),
wherein the local interconnect (140, 4140) comprises a first portion (121) abutting the first S/D region (111), a second portion (222, 532), abutting the transistor feature, and an intermediate portion (131, 4141) extending between the first and second portions through a cut-out (131c) formed in the first gate structure (131).

2. The semiconductor device according to claim 1, wherein the cut-out (131c) is formed in the first gate structure (131) at a position between the first and second active regions (100, 200).

3. The semiconductor device according to any one of the preceding claims, wherein the cut-out (131c) is configured as a downwardly extending recess in a top side of the first gate structure (131).

4. The semiconductor device according to any one of claims 1-2, wherein the cut-out (131c) is configured as an upwardly extending recess in a bottom side of the first gate structure (131).

5. The semiconductor device according to any one of the preceding claims, wherein the intermediate portion (141) of the local interconnect (140) does not extend above a level of a top side of the first gate structure (131).

6. The semiconductor device according to any one of claims 1-2, wherein the cut-out (131c) is configured as a downwardly extending recess in a top side of the first gate structure (131), and wherein the intermediate portion (141) of the local interconnect (140) comprises a lower portion extending through the cut-out (131c) and an upper portion extending above a level of the top side of the first gate structure (131).

7. The semiconductor device according any one of the preceding claims, wherein the intermediate portion (1141, 2141) extends along a curvilinear and/or diagonal path between the first portion (121) of the local interconnect (1140, 2140) and the cut-out in the first gate structure (131), and/or between the cut-out in the first gate structure (131) and the second portion (222) of the local interconnect (1140, 2140).

8. The semiconductor device according to any one of the preceding claims, wherein the first channel region (101) of the first active region (100) belongs to a first transistor of a first transistor type and the first channel region (201) of the second active region (200) belongs to a first transistor of a second transistor type, wherein the first transistor type is an n-type transistor and the second transistor type is a p-type transistor, or vice versa.

9. The semiconductor device according to claim 8, wherein the transistor feature is a second gate structure (132) of the circuit cell (10, 20), consecutive to and parallel to the first gate structure (131), and wherein the local interconnect (4140) further comprises a third portion (221) abutting a first S/D region (211) of the second active region (200) disposed directly opposite the first S/D region (111) of the first active region (100).

10. The semiconductor device according to claim 9, wherein the first and third portions (121, 221) of the local interconnect (4140) extend to join with the intermediate portion (4141) at a location at the first side of the first gate structure (131) and between the first and second active regions (100, 200).

11. The semiconductor device according to any one of claims 9-10, wherein the second gate structure (132) extends to overlap a respective second channel region of each of the first and second active regions (100, 200), wherein the second channel region of the first active region (100) belongs to a second transistor of the first transistor type and the second channel region of the second active region (200) belongs to a second transistor of the second transistor type.

12. The semiconductor device according to claim 11, wherein the first transistors are configured as a first inverter pair of the circuit cell (20) and the second transistors are configured as a second inverter pair of the circuit cell (20).

13. The semiconductor device according to claim 8, wherein the transistor feature is a second S/D region (212) of the second active region (200).

14. The semiconductor device according to claim 13, wherein the second S/D region (212) of the second active region belongs to the first transistor of the second transistor type.

15. The semiconductor device according to claim 8,
wherein each circuit cell (10) further comprises a second gate structure (132) consecutive to and parallel to the first gate structure (131),
wherein the transistor feature is a second S/D region (123, 223) of the first or second active region (100, 200) located past the second gate structure (132), and
wherein the intermediate portion (3141) of the local interconnect extends between the first and second portions (121, 123, 223) through the cut-out formed in the first gate structure (131) and a cut-out formed in the second gate structure (132).
